# EUROPEAN PATENT SPECIFICATION

(11) **EP 4 565 539 B1**
(45) Date of publication and mention of the grant of the patent: **23.09.2026**
(21) Application number: 23748492.8
(22) Date of filing: 25.07.2023
(51) Int. Cl.: C03C 17/28, C03C 17/30, C03C 17/36

(54) **BORON DOPED SILICON OXIDE PROTECTIVE LAYER AND METHOD FOR MAKING THE SAME**
BORDOTIERTE SILIZIUMOXID-SCHUTZSCHICHT UND VERFAHREN ZUM HERSTELLEN DERSELBEN
COUCHE DE PROTECTION D'OXYDE DE SILICIUM DOPÉ AU BORE ET SON PROCÉDÉ DE FABRICATION

(30) Priority: 04.08.2022 EP 22188892
(43) Date of publication of application: 11.06.2025
(73) Proprietor: AGC Glass Europe, 1348 Louvain-La-Neuve (BE)
(72) Inventor: MICHEL, Eric, 6041 Gosselies (BE); TIXHON, Eric, 6041 Gosselies (BE)
(74) Representative: Rupp, Christian
(86) International application number: PCT/EP2023/070636
(87) International publication number: WO 2024/028173

(56) References cited:
- EP-A1- 2 857 370
- WO-A1-03/068500
- WO-A1-2018/052760
- US-A- 5 709 930

## Description

### TECHNICAL FIELD

The present invention relates glass substrate bearing a multilayer coating comprising a layer of boron doped silicon oxide for protecting a multilayer coating from chemical degradation. The present invention further concerns a plasma enhanced chemical vapor deposition method for depositing such a protective layer, in particular on large glass substrates, for example of a size up to at least 3.2*6m². The protective layer of the present invention may further maintain a refractive index that is very close to that of undoped silicon oxide.

### BACKGROUND ART

Multilayer coatings provide coated glass substrates with a variety of properties, they may in particular provide solar control, insulating, antireflective, and/or anti bird collision properties.

Such coatings are frequently deposited using magnetron sputtering and may comprise dielectric layers, transparent conductive oxide layers and metal layers for example. They are subjected to mechanic and chemical stress during handling, transport, and processing into finished windows. During these steps, the multilayer coatings are exposed to conditions that may lead to corrosion of the coating, resulting in defects such as point defects or even delamination.

Several protective coatings for glass substrates have are known in the area of glazing. They are generally used to provide magnetron sputtered coatings with additional resistance against different mechanical and/or chemical attacks.

EP2262745A1 for example describes glass substrates bearing solar control or lowE insulating coatings bearing a protective topcoat based on titanium oxide and an additional oxide of ZrO₂, SiO₂, or Cr₂O₃. This protective topcoat provides mechanical and chemical durability, however the refractive index of these coatings is high, generally at least 2.0 at a wavelength of 633nm. Such high refractive index layers tend to increase the reflectance of the resulting coating stacks, in particular at higher thicknesses, which is not desired in many applications, and are therefore limited in their thickness.

WO03068500A1 discloses protective topcoats having lower refractive indexes made of mixed oxides of aluminum and silicon. These protective topcoats are however economically uninteresting as they have low deposition rates. Furthermore, their resistance to mechanical and chemical degradation was found to be insufficient.

EP2857370A1 discloses plasma enhanced chemical vapor deposited SiO2 layers that have good deposition rates and good resistance to heat treatments. It was found however that chemical resistance of these layers can still be improved.

US 5 709 930 A is directed to a glass substrate bearing a multicoating, such as used in mirrors, decorative products and solar screening panels for use in buildings and vehicles. The coated substrate comprises a substrate and at least one primary coating layer formed thereon, characterised by an exposed protective additional layer, formed thereon by cathode vacuum sputtering, of a material with a refractive index of less than 1.7 and selected from oxides and oxynitrides of silicon, and mixtures of one or more of oxides, nitrides and oxynitrides of silicon, said protective layer having a thickness of from 1 to 10 nm. The coated substrates are said to possess improved chemical and/or mechanical durability, while minimising any consequential changes in the optical properties.

There is a need in the art for layers that improve multilayer coating resistance to chemical degradation and that have a low refractive index and that may be deposited with high deposition rates.

### SUMMARY OF INVENTION

It is an object of the present invention to provide a glass substrate bearing a multilayer coating comprising a protective layer that provides increased chemical resistance to the coated substrate and that preferably has a low refractive index in the visible light range.

Thus, the present invention concerns a glass substrate bearing a multilayer coating comprising a protective layer of boron doped silicon oxide, wherein the boron doped silicon oxide comprises Si, O, B, and OH groups and wherein the boron content is comprised between 4 at 12 atomic %.

It is another objective of the present invention to provide a method for the deposition of a protective layer boron doped silicon oxide, wherein the boron doped silicon oxide comprises Si, O, B, and OH groups and wherein the boron content is comprised between 4 at 12 atomic %.

The inventive process for the deposition on a glass substrate of a protective boron doped silicon oxide layer comprising Si, O, B, and OH groups and wherein the boron content is comprised between 4 at 12 atomic %, comprises:
a. providing a glass substrate,
b. providing a plasma source, of linear hollow-cathode type, which source has a length, comprising at least one pair of hollow-cathode plasma generating electrodes, and comprises at least one electrode pair connected to an AC, DC or pulsed DC generator power source, for the deposition of said protective layer on the substrate,
c. injecting a plasma generating reactive gas comprising oxygen in the plasma source's electrodes at a flow rate of between 125 and 750 sccm per linear meter of plasma source length;
d. applying an electrical power to the plasma source of between 10 and 50 kW per linear meter of plasma source length, and,
e. injecting a precursor gas at a flow rate of between 500 and 2500 sccm per linear meter of plasma source length, the precursor gas being injected into the plasma in at least between the electrodes of each electrode pair of the plasma source, depositing the protective layer on the glass substrate by exposing the substrate to the plasma of the plasma source.

### BRIEF DESCRIPTION OF THE FIGURES

For a fuller understanding of the nature of the present invention, reference is made to the following detailed description taken in conjunction with the accompanying drawings in which:
Figure 1 shows a transverse section of a hollow cathode type linear plasma source comprising one electrode pair for depositing the protective layer of the present invention.
Figure 2 shows the deposition section of a hollow cathode type linear plasma source for the continuous deposition the protective layer of the present invention in relation to a substrate.
Figures 3 and 4 show two different embodiments of glass substrates bearing multilayer coatings comprising a protective layer of boron doped silicon oxide.

### DETAILED DESCRIPTION OF THE INVENTION

Multilayer coatings are coatings comprising two or more thin layers. Thin layers are layers having a thickness of up to 1µm. Multilayer coatings provide glass substrates with modified optical and/or energetical properties.

In certain embodiments of the present invention the coating is selected from antireflective coatings, ultraviolet (UV) reflective coatings for preventing bird collisions, insulating low emissivity coatings and solar control coatings. In certain embodiments of the present invention the boron doped silicon oxide layer is the protective topcoat in the coating provided on a substrate, i.e. the last, or topmost, layer of the multilayer coating, furthest away from the substrate. The boron doped silicon oxide layer of the present invention may alternately be used in other positions of layer sequence making up a multilayer coating.

In an embodiment of the present invention, the protective layer may have a refractive index between 1.4 and 1.8 at a wavelength of 633nm and/or comprise at least 80 weight% of SiO₂. In multilayer coatings, thicker, lower refractive index layers may replace thinner, higher refractive index layers; multilayer coatings may benefit from the improved protection of thicker protective layers.

In certain embodiments of the present invention the coating is an antireflective coating, comprising an alternating sequence of high refractive index layers and low refractive index layers, wherein the boron doped silicon oxide layer is one of the low refractive index layers, preferably a protective topcoat layer. The low refractive index layers may have a refractive index between 1.4 and 1.8 at a wavelength of 633nm and may be layers comprising at least 80 weight% of SiO₂. The high reflective layers may have a refractive index of at least 2.0 at a wavelength of 633nm and may for example be selected from layers comprising titanium oxide or mixed titanium zirconium oxide, niobium oxide, a mixed nitride of silicon and zirconium. The thus antireflective coated substrate has a visible light reflectance lower than the uncoated substrate.

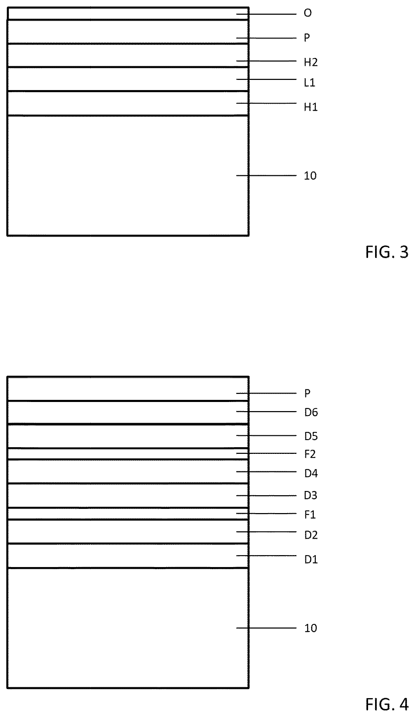

Figure 3 illustrates a glass substrate (10) bearing a multilayer coating of alternating high refractive index layers (H1, H2) and low refractive index layers (L1, P) and an optional layer (O) for mechanical protection. One of the low refractive index layers (P) is a boron doped silicon oxide protective layer according to an embodiment of the present invention.

In certain embodiments of the present invention, the coating is a UV reflective coating, for example an anti-bird collision coating, wherein the boron doped silicon oxide layer is a low refractive index layer, preferably a protective topcoat layer. Such UV reflective coatings generally comprise an alternating sequence of high refractive index and low refractive index layers. The low refractive index layers may have a refractive index between 1.4 and 1.8 at a wavelength of 633nm and may be layers comprising at least 80 weight% of SiO₂. The high reflective layers may have a refractive index of at least 2.0 at a wavelength of 633nm and may for example be selected from layers comprising titanium oxide or mixed titanium zirconium oxide, niobium oxide, a mixed nitride of silicon and zirconium. The thus UV reflective coated substrate has a UV light reflectance higher than the uncoated substrate.

In an embodiment, the present invention relates to a multilayer coating comprises n functional layer(s) reflecting infrared radiation and n+1 dielectric coatings, with n≥1, each functional layer being surrounded by dielectric coatings. The dielectric coatings may comprise one or more dielectric layers for example selected from layers of oxides, nitrides or oxynitride of metals or silicon or mixtures thereof and/or a boron doped silicon oxide protective layer of the present invention. One or more dielectric layers may for example be selected from mixed zinc tin oxide, silicon nitride, mixed tin antimony oxide, zinc oxide, titanium oxide, mixed titanium zirconium oxide. In particular, the topmost layer, furthest away from the substrate, may be a boron doped silicon oxide protective layer of the present invention.

Multilayer low-emissivity insulating coatings generally include a single functional layer reflecting infrared radiation, whilst multilayer coatings having low-emissivity and anti-solar properties generally include two or three functional layers reflecting infrared radiation. Preferably functional layers reflecting infrared radiation in multilayer coatings of the present invention are silver-based layers, consisting of silver or silver doped with for example palladium or gold, in a proportion of at most 5 weight%, preferably around 1 weight%. Incorporation of a low quantity of such a dopant in the silver-based layer may improve the chemical durability of the coating stack. In advantageous embodiments, functional layers have a thickness of at least 6 nm or at least 8 nm, preferably at least 10 nm; its thickness is preferably at most 22 nm or at most 20 nm, preferably at most 18 nm, or at most 16 nm. Such ranges of thickness allow to reach the sought low emissivity and/or anti-solar properties, whilst limiting the light absorption of these layers. In the case of multilayer coatings with two functional layers reflecting infrared radiation, it may be preferred that the thickness of the second functional layer, i.e. the one furthest away from the substrate, be slightly greater than the thickness of the first functional layer. As an example, the first functional layer may have a thickness between 8 and 18 nm and the second functional layer between 10 and 20 nm.

According to an embodiment of the present invention, at least one dielectric layer above or below a functional layer comprises a layer consisting essentially of boron doped silicon oxide. This means, for example, that in a single functional layer configuration stack, a boron doped silicon oxide layer is present in the second, upper dielectric coating, or in the first lower dielectric coating and in a double functional layer multilayer coating, a boron doped silicon oxide layer is present either in the first, second, or third dielectric coating, or in any two dielectric coatings, or in each of the three dielectric coatings.

Figure 4 shows a glass substrate (10) bearing a multilayer coating comprising two silver functional layers (F1, F2) each surrounded by dielectric layers (D1 to D6), further comprising as uppermost layer a protective boron doped silicon oxide layer (P) of the present invention.

In an embodiment of the present invention, the boron doped silicon oxide protective layer of the present invention is a layer in a multilayer coating comprising infrared reflective functional layers other than silver-based layers, such as for example other metal or metal alloy layers, such as Cr and NiCr alloy or stainless steel for example and also transparent conductive oxide layers, such as ITO (indium doped tin oxide) for example. An example embodiment could be for example: a first layer on the glass substrate of an oxide of titanium, zirconium, and/or niobium, a second layer consisting of at least 85 wt% of SiO₂, a third layer of indium doped tin oxide, a fourth layer of boron doped silicon oxide according to any embodiment described herein, and optionally, a fifth layer, providing further increased mechanical protection, such as a zirconium doped silicon oxide layer or a mixed titanium zirconium oxide layer, a zirconium oxide layer, or a mixed silicon zirconium nitride layer.

The boron doped silicon oxide protective layer of the present invention comprises OH groups. The presence of OH groups is a feature that distinguishes these coatings from magnetron sputtered coatings, which do not provide the same level of protection. To the best of the inventors' knowledge, it may be at least partly due to this combination of OH groups and boron doping that the boron doped silicon oxide layer of the present invention has protective abilities. The presence of OH groups can be determined by Fourier Transform Infrared spectroscopy (FTIR) on an equivalent protective layer deposited on a silicon substrate. The presence of OH groups in the protective layer are detected by the presence of an absorption peak at a wavenumber of 3300 to 3500cm⁻¹, corresponding to an -OH stretching vibration. Additional absorption peaks corresponding to Si-OH stretching vibrations may be visible between 900 and 1000 cm-1, these peaks may however overlap with the more intense peak of Si-O stretching vibrations.

In an embodiment of the present invention the FTIR absorbance peak area ratio A_{OH}/A_{SiOSi} of the -OH stretching vibrations (A_{OH}) and the Si-O-Si stretching vibrations (A_{SiOSi}) is comprised between 0.25 and 0.5. The absorption peak for -OH stretching vibrations appears at a wavenumber of 3300 to 3500cm⁻¹, the absorption peak for Si-O-Si stretching vibrations appears at a wavenumber of 1080 to 1090cm⁻¹.

In SiO₂ based coatings deposited by sputtering, some hydrogen may be unintentionally present in the gas phase, in the coating however, the FTIR absorbance peak area ratio A_{OH}/A_{SiOSi} was found to be <0.05. Furthermore, SiO2 based coatings deposited by sputtering generally comprise aluminum, as aluminum is added to silicon sputtering targets to increase its conductivity. The boron doped silicon oxide layers of the present invention may be free of aluminum.

The boron doped silicon oxide layers of the present invention were found to be amorphous and non-porous, as seen for example by transmission electron microscopy.

The boron doped silicon oxide layers of the present invention comprise or may essentially consist of silicon, boron, oxygen and hydrogen.

In any of the embodiments hereinabove, the boron doped silicon oxide layer has a boron content from 4 to 12 at% of B. Within this doping range, the refractive index may remain very low, that is, comprised between 1.4 and 1.5 at a wavelength of 633nm, in particular if the SiO₂ content by weight is at least 80%. At the same time, good chemical resistance of the multilayer coating is obtained and the haze level after thermal strengthening can be kept low and may in particular be kept at values below 0.3%.

The content of boron in the boron doped silicon oxide layer is preferably determined by x-ray photoelectron spectroscopy (XPS) or else by secondary ionization mass spectrometry (SIMS) using appropriate standards for a quantitative appreciation.

According to an embodiment of the present invention, boron doped silicon oxide protective layer may have a thickness of at least 50nm, preferably at least 80nm to show a more noticeable improvement of durability. The thickness may be adapted over a wide range so as to adjust the optical properties of the final coated product. Thus, the thickness of the boron doped silicon oxide layer may be up to 400nm, in particular up to 350nm, more particularly up to 300nm. Such high thicknesses are not suitable for magnetron sputtering deposition, due to the slow deposition rates of silicon oxide base coatings.

According to an embodiment of the present invention, the boron doped silicon oxide layers of the present invention may have an atomic ratio of O/Si comprised between 1.9 and 2.6. It was found that at lower boron doping levels the O/Si atomic ratio was lower.

According to an embodiment of the present invention, the boron doped silicon oxide coating of the present invention may, in particular, be free of carbon. Absence of carbon may be particularly interesting for reducing absorptance of the layer and may help reducing the number of defects that occur upon thermal strengthening of the coated products. The presence of carbon is a significant drawback of sol-gel coatings, in addition to the complications of integrating a sol gel coating process in a multilayer coating process.

For the purpose of the present invention, a layer is considered to be free of carbon when no carbon signal is detectable above signal noise for carbon of either x-ray fluorescence spectroscopy or secondary ion mass spectroscopy signals. It should be noted that surface contamination, in particular of carbon, that occurs naturally on coatings upon exposure to free air shall be ignored upon analysis.

The boron doped silicon oxide toplayer of any of the embodiments or combinations of embodiments hereinabove may advantageously be deposited using plasma enhanced chemical vapor deposition (PECVD), in particular using a linear plasma source, such as a hollow cathode plasma source. By operating under vacuum, PECVD can be easily integrated into a vacuum multilayer coating line, such as a magnetron sputtering line.

The invention relates to a process for the deposition on a glass substrate of a multilayer coating comprising a boron doped silicon oxide protective layer, wherein the protective layer comprises Si, O, B, wherein the boron content is comprised between 4 at 12 atomic % and OH groups, comprising:
a. providing a glass substrate,
b. providing a plasma source, of linear hollow-cathode type, which source has a length, comprising at least one pair of hollow-cathode plasma generating electrodes connected to an AC, DC or pulsed DC generator power source, for the deposition of said protective layer on the substrate,
c. injecting a plasma generating reactive gas comprising oxygen in the plasma source's electrodes at a flow rate of between 125 and 750 sccm per linear meter of plasma source length;
d. applying an electrical power to the plasma source of between 10 and 50 kW per linear meter of plasma source length so as to generate a plasma, and,
e. injecting a precursor gas comprising boron, silicon and hydrogen at a flow rate of between 500 and 2500 sccm per linear meter of plasma source length, the precursor gas being injected into the plasma at least in between the electrodes of each electrode pair of the plasma source, depositing the protective layer on the glass substrate by exposing the substrate to the plasma of the plasma source.

Standard cubic centimeters per minute, "sccm", is a unit of flow measurement indicating cubic centimeters per minute (cm³/min) in standard conditions for temperature and pressure of a given fluid. These standard conditions are for the present invention fixed at a temperature of 0 °C (273.15 K) and a pressure of 1.01 bar.

According to an embodiment of the present invention, the multilayer coating further comprises one or more layers for example deposited by magnetron sputtering and/or PECVD. Optionally additional coatings may be deposited by the same technologies for example after the deposition of the protective layer. Thereby multilayer coatings as described hereinabove, comprising a protective boron doped silicon oxide layer, may be formed.

Stage b) of the process of the present invention requires a low-pressure PECVD plasma source, which pressure is preferably between 0.13 and 66.66 Pa (0.001 and 0.5 Torr), preferably between 0.13 and 4.00 Pa and more preferably between 0.40 and 2.67 Pa, which device is provided with a linear plasma source of hollow-cathode type, comprising at least one electrode pair, connected to an AC or pulsed DC generator, the frequencies of which are usually between 5 and 150 kHz, preferably between 5 and 100 kHz, or to a DC generator. The pressure is maintained by vacuum pumps.

A PECVD device example is described below. The PECVD source is connected to or provided in a vacuum chamber. This vacuum chamber is arranged so that it makes it possible to have, next to one another, several PECVD devices or else other deposition sources having different deposition forms, in the same vacuum chamber or in separate, connected vacuum chambers. In certain applications, these other deposition sources, which make possible different deposition forms, are flat or rotating cathodes for magnetron sputtering deposition. The deposition sources are chosen and combined in a coater so as to provide the deposition process of a multilayer coating comprising the protective layer of the present invention, in particular on glass substrates having dimensions up to at least 3.2 x 6 m².

The vacuum chamber may be part of a horizontal coater or of a vertical coater and may further comprise a transfer chamber.

Linear plasma sources are particularly useful for depositing uniform layers on large substrates in a dynamic or continuous coating process. They are placed perpendicularly to the travelling direction of the substrates so as to span in their lengthwise direction over the width of the substrates. An advantage of linear plasma sources is their scalability. Their length may thus be adapted to span substrates of different widths, the applied power and the gas flow and precursor flow rates being adapted proportionally to the length. The width of linear plasma sources extends parallel to the travelling direction of the substrate. Showerhead type plasma sources or point plasma sources are in particular less suitable for large substrates extending over more than 1x1m² as coating of such large substrates requires complicated arrangements such as arrays of multiple sources for example and uniformity is difficult to achieve.

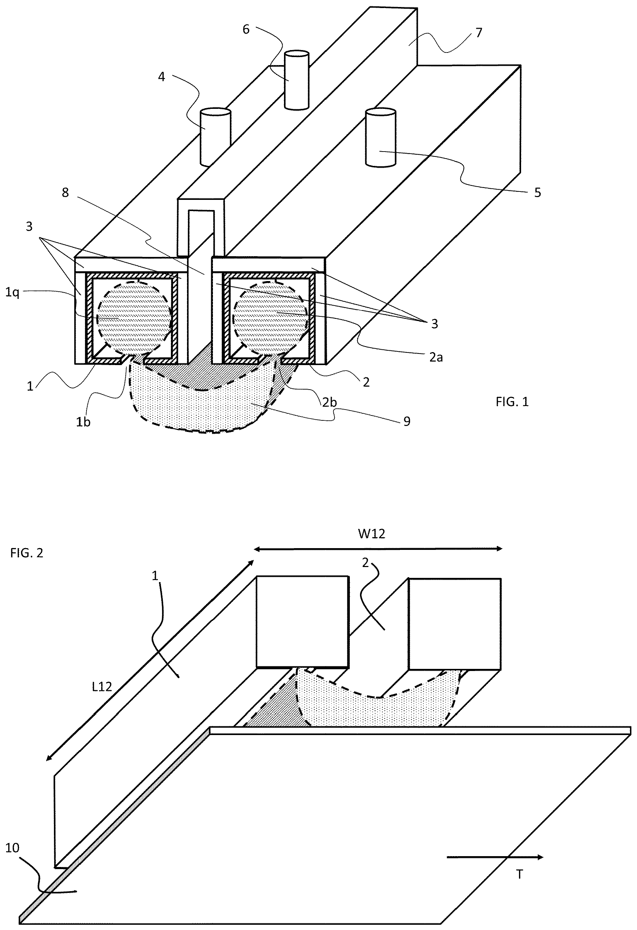

"Plasma source of hollow cathode type," is taken to mean a plasma or ion source comprising one or more electrodes configured to produce hollow cathode discharges. One example of a hollow cathode plasma source is described in US8652586, incorporated herein by reference in its entirety. Figure 1 shows a plasma source of hollow cathode type that may be used in the present invention. The plasma source comprises at least one pair of hollow cathode electrodes (1, 2), arranged in parallel and connected via an AC power source (not shown). Electrically insulating material (3) is disposed around the hollow cathode electrodes. The plasma generating gas is supplied via the inlets (4) and (5). The precursor gas is supplied via the precursor gas inlet (6) and led through manifold (7) and precursor injection slot (8) in the dark space between the electrodes, into the plasma curtain (9). The AC power source supplies a varying or alternating bipolar voltage to the two electrodes. The AC power supply initially drives the first electrode to a negative voltage, allowing plasma formation, while the second electrode is driven to a positive voltage in order to serve as an anode for the voltage application circuit. This then drives the first electrode to a positive voltage and reverses the roles of cathode and anode. As one of the electrodes is driven negative, a discharge (1a, 2a) forms within the corresponding cavity. The other electrode then forms an anode, causing electrons to escape the plasma through the outlet (1b, 2b) and travel to the anodic side, thereby completing an electric circuit. A linear plasma having a curtain shape (9) is thus formed in the region between the first and the second electrodes above the substrate (10) as shown on Figure 2. This method of driving hollow cathodes with AC power contributes formation of a uniform linear plasma that spans across the substrate (10), the length (L12) of the plasma source being perpendicular to the travelling direction (T) of the substrate and the width (W12) of the plasma source being parallel to the travelling direction (T) of the substrate.

In linear hollow cathode type plasma sources, it is possible to create a uniform plasma without relying on closed circuit electron drift. "Closed circuit electron drift" is taken to mean an electron current caused by crossed electric and magnetic fields. In many conventional plasma forming devices, the closed circuit electron drift forms a closed circulating path or "racetrack" of electron flow.

"AC power" is taken to mean electric power from an alternating source wherein the voltage is changing at some frequency in a manner that is sinusoidal, square wave, pulsed or some other waveform. Voltage variations are often from negative to positive, i.e. with respect to ground. When in bipolar form, power output delivered by two leads is generally about 180° out of phase.

"Electrodes" provide free electrons during the generation of a plasma, for example, while they are connected to a power supply providing a voltage. The electron-emitting surfaces of a hollow cathode are considered, in combination, to be one electrode. Electrodes can be made from materials well-known to those of skill in the art, such as steel, stainless steel, copper, or aluminum. However, these materials must be carefully selected for each plasma-enhanced process, as different gasses may require different electrode materials to ignite and maintain a plasma during operation. It is also possible to improve the performance and/or durability of the electrodes by providing them with a coating.

For any plasma source of the present invention, the power density of the plasma is defined as being the power dissipated in the plasma generated at the electrode(s), with reference to the size of the plasma. In a linear hollow-cathode type plasma source, the "power density of the plasma" can be defined as the total power applied to the source, divided by the total length of the plasma source.

The "linear meter of plasma length", refers to the length of the plasma which is defined as the distance between the ends of the plasma generated by a pair of electrodes, in the direction transversal to the travelling direction of the substrate to be coated. When the plasma source comprises more than one pair of electrodes, the length of the plasma is defined as the sum of the distances between the ends of the plasmas generated by each pair of electrodes, in the direction transversal to the travelling direction of the substrate to be coated. As may be well understood by any person skilled in the art, these linear hollow cathode plasma sources are scalable in that their length may be adapted so as to span the width of the substrate to be treated. Plasma source lengths may for example be of several meters. It makes sense therefore to express flow rates and applied power in units dependent on the overall length of the plasma source, as for example doubling the length of a plasma source obviously requires doubling the applied power and flow rates.

As used herein, the following terms have the following meanings: "A", "an", and "the" as used herein refers to both singular and plural referents unless the context clearly dictates otherwise. By way of example, "a chamber" refers to one or more than one chamber.

"Comprise," "comprising," and "comprises" and "comprised of" as used herein are synonymous with "include", "including", "includes" or "contain", "containing", "contains" and are inclusive or open-ended terms that specifies the presence of what follows e.g. component and do not exclude or preclude the presence of additional, non-recited components, features, elements, members or steps, known in the art or disclosed therein.

The recitation of numerical ranges by endpoints includes all numbers and fractions subsumed within that range, as well as the recited endpoints.

The pairs of electrodes, forming cavities in which the plasma discharge takes place, are each connected to pipes for the introduction of a reactive plasma generating gas and provided with openings from where the ionized gas, i.e. the plasma, is expelled.

The frequency of the power source connected to the electrodes may be between 5 and 150 kHz, preferably between 5 and 100 kHz.

The at least one pair of electrodes of the linear plasma source is may have a length of between 250 mm and 4000 mm and between 100 and 800 mm in width.

Such values have the advantage of ensuring an amount of reactive gas which is sufficiently greater than that of the precursors, making it possible to control and/or avoid the incorporation of carbon in the layer. Applied power, reactive gas and precursor flow rates are adapted proportionally to the length of the linear plasma source.

The power source provides a power preferably between 5 kW per linear meter of plasma source length and 50 kW, advantageously between 10 and 35 kW per linear meter of plasma source length. Below this power of 5 kW per linear meter of plasma source, presence of carbon in the protective layer is observed and above 50 kW per linear meter of plasma source, arc formation may be observed which is detrimental to the lifetime of the plasma source and/or the quality of the coating.

The reactive gas comprises oxygen or on oxygen-comprising derivatives, the latter preferably being chosen from the group consisting of ozone, hydrogen peroxide, water and CO₂. According to embodiments, the reactive gas can in addition advantageously include an inert gas, such as helium, nitrogen, argon, neon or krypton, in order to promote the chemical dissociation of the precursors and to control the ion bombardment by the source. If present, the percentage of inert gas in the reactive gas is comprised between 2% and 50% by volume, preferably between 3% and 10% by volume, more preferably between 4% and 7% by volume. This choice makes it possible to control the coverage of the layer obtained

The reactive gas is preferably O₂ or an O₂-Ar mixture.

In an embodiment of the present invention, the reactive gas flow rate is comprised between 2000 and 5000 sccm per linear meter of plasma source length.

The precursor gas comprising boron, silicon and hydrogen is injected uniformly along the length plasma source into the plasma. The precursor may for example be injected in between the electrodes of an electrode pair and/or, if there are more than one electrode pairs, between adjacent electrode pairs. This precursor gas is activated by this plasma. The substrate is taken close to the source and a thin layer is deposited on the substrate from the activated gas.

The precursor gas flow rate is preferably between 125 and 750 sccm per linear meter of plasma source length. Generally, if the precursor gas comprises a mixture of precursors, then the precursor gas flow rate is the sum of the flow rates of the precursors of the mixture.

The distance between the substrate surface and the opening of the plasma source, via which the plasma is emitted out of the source, is preferably at least 2.0 to 20 cm, more preferably at least 4 to 15 cm.

Preferably, the ratio of the reactive gas flow rate to the precursor gas flow rate is at least 3, advantageously between 3 and 50.

The precursor gas comprises silicon, boron and hydrogen and may in particular further comprise carbon and/or oxygen.

The precursor gas may comprise a single precursor, meaning a single precursor or may comprise a mixture of precursors, meaning a mixture of different precursor of different composition. The ratio of precursors is adapted to set the boron doping at the desired level, in particular for boron content from 4 to 12 at% of B in the boron doped silicon oxide layer.

According to an embodiment of the present invention, the precursor gas comprises at least one precursor comprising Si, at least one precursor comprising B and/or at least one precursor comprising Si and B. Any of the precursors in the precursor gas may further comprise hydrogen. Any of the precursors in the precursor gas may further comprise carbon. Any of the precursors may further comprise oxygen.

The temperature to which the substrate may be brought during deposition of the protective layer is between 20°C and 60°C depending on the residence time of the substrate in the plasma, for instance depending on the speed of displacement of the substrate beneath the plasma source.

In an embodiment of the present invention, a precursor comprising silicon is free of boron, that is does not comprise boron, and is preferably of the formula (I), (II), (III), (IV) or (V).

Y₁ -X-Y₂ (I)

or

-[Si(CH₃ )_{q} (H)_{2-q} -X-]ₙ - (II)

or

CH₂ = C(R₁ )-Si(R₂ )(R₃ )-R₄ (III)

or

R₅ -Si(R₆ )(R₇ )-R₈ (IV)

or

CH₂=C(R₉)C(O)-O-(CH₂)ₚ -Si(R₁₀ )(R₁₁ )-R₁₂ (V)

wherein for Formula (I) X is O or NH, Y₁ is -Si(Y₃ )(Y₄ )Y₅ and Y₂ is Si(Y_{3'})(Y_{4'})Y_{5'} wherein Y₃, Y₄, Y₅, Y_{3'}, Y_{4'}, and Y_{5'} are each independently H or an alkyl group of up to 10 carbon atoms; wherein at most one of Y₃, Y₄ and Y₅ is hydrogen, at most one of Y_{3'}, Y_{4'} and Y_{5'} is hydrogen; and the total number of carbon atoms is not more than 20.
wherein Formula (II) is cyclic where n is 2 to 10, wherein q is 0 to 2 and wherein the total number of carbon atoms is not more than 20.
wherein for Formula (III) R₁ is H or an alkyl group, e.g. -CH₃, and wherein R₁, R₂ and R₃ are each independently H, an alkyl group of up to 10 carbon atoms or an alkoxy group -O-Z, wherein Z is preferably -CₜH₂ₜ₊₁, wherein t is 1 to 10.
wherein for Formula (IV) R₅ is H or an alkyl group, e.g. -CH₃, and wherein R₆, R₇ and R₈ are each independently H, an alkyl group of up to 10 carbon atoms or an alkoxy group -O-Z, wherein Z is preferably -CₜH₂ₜ₊₁, wherein t is 1 to 10.
wherein for Formula (V) R₉ is H or an alkyl group, e.g. -CH₃, wherein p is from 0 to 10, and wherein R₁₀, R₁₁ and R₁₂ are each independently H, an alkyl group of up to 10 carbon atoms or an alkoxy group -O-Z, wherein Z is preferably -CₜH₂ₜ₊₁, wherein t is 1 to 10.

The alkyl groups may be straight or branched-chain but straight groups are preferred. Such alkyl groups are aptly methyl or ethyl groups of which methyl is preferred. Aptly all of Y₃, Y₄, Y₅, Y_{3'}, Y_{4'} or Y_{5'} are alkyl groups.

The alkoxy groups may be straight, branched-chain or cyclic but straight groups are preferred. Such alkoxy groups are aptly methoxy or ethoxy groups.

The silicon-comprising precursor of Formula I may be one containing six methyl groups. Aptly the silicon-comprising precursor of Formula I is hexamethyldisiloxane (HMDSO), hexamethyldisilazane or tetramethyldisiloxane (TMDSO).

The silicon-comprising precursor of Formula II may be one wherein n is 3, or n is 4, or n is 5, or n is 6. Aptly the silicon-comprising precursor of Formula II is octamethylcyclotetrasiloxane. Aptly the silicon-comprising precursor of Formula II is hexamethylcyclotrisilazane.

The silicon-comprising precursor of Formula V may be one wherein p is 2 and wherein each of R₁₀, R₁₁ and R₁₂ are an alkoxy group, e.g. methoxy. Aptly the silicon-comprising precursor of Formula V is 3-(trimethoxysilyl)propyl methacrylate. Aptly the silicon-comprising precursor of Formula V is 3-(trimethoxysilyl)propyl acrylate.

In an embodiment of the present invention, a precursor comprising boron is free of silicon, meaning is not comprising Si, and is preferably of the formula (VI):

R₁₃ -B(R₁₄ )(R₁₅ ) (VI)

wherein R₁₃, R₁₄ and R₁₅ are each independently H, an alkyl group of up to 10 carbon atoms or an alkoxy group -O-Z, wherein Z is preferably -CₜH₂ₜ₊₁, wherein t is 1 to 10.

The alkyl groups may be straight or branched-chain but straight groups are preferred. Such alkyl groups are aptly methyl or ethyl groups of which methyl is preferred.

The alkoxy groups may be straight, branched-chain or cyclic but straight groups are preferred. Such alkoxy groups are aptly methoxy, ethoxy, or isopropoxy groups.

In an embodiment of the present invention, for Formula (VI), R₁₃, R₁₄ and R₁₅ are all ethoxy or R₁₃, R₁₄ and R_{15 are} all isopropoxy groups.

In an embodiment of the present invention, a boron and silicon comprising precursor is of the formula (VII):

R₁₆O -B(-OR₁₇ )(-OR₁₈ ) (VII)

Wherein R16, R17, and R18 are all independently organosilyl groups, in particular trialkylsilyl groups, an alkyl group of up to 10 carbon atoms. Aptly such trialkylgroups are trimethylsilyl, triethylsilyl or diethyl(methyl)silyl groups. Aptly such a boron and silicon precursors is tris(trimethylsilyl)borate (TTMSB).

Preferably, any precursor of boron, silicon and/or both silicon and boron is transported to the plasma source without the use of a carrier gas. However, in some embodiments, an additional gas may be used as carrier gas to introduce a precursor into the plasma chamber.

Preferably any precursor is supplied as a liquid which is subsequently vaporized and transported to the plasma source in its vaporized form. Preferably any vaporized precursor is transported to the plasma chamber without the use of a carrier gas. Alternatively, if necessary, the liquid precursor supply system uses a carrier gas to transport the vaporized precursor into the plasma chamber.

Preferably, when a carrier gas is used, the carrier gas is selected from N₂ , He or Ar, and/or any mixture of these gases. In one preferred process, a single carrier gas is used. This is most preferably He or Ar.

Preferably, when a carrier gas is used, the amount of carrier gas is about 5 % to about 1500 % carrier gas based on the total flow of all silicon and boron precursors, preferably about 10 % to about 1000 % additional gas, more preferably 20 % to 750 %, for example 25 % to 500 %, such as 500, 450, 400, 350, 300, 250, 200, 175, 150, 125, 100, 90, 80, 75, 70, 60, 50, 40, 35, 30, or 25 % carrier gas.

Any precursors may be gaseous at room temperature and pressure, or may be vaporized liquids.

The flow rates of the different precursors below are necessary in order to obtain high dynamic deposition rates, in the order of 20 to 500 nm.m/min. Generally higher precursor flow rates require higher power applied to the plasma source.

In an embodiment of the present invention the total flow rate of the silicon-comprising precursors is comprised between 10 and 500 sccm (standard cubic centimeters per minute) per linear meter of plasma length, preferably between 50 and 500 sccm or between 50 and 400 sccm per linear meter of plasma length.

The unit « nm.m/ min » is used in the present application to express the deposition rate. This unit is a combination of SI units which is typically used to characterize deposition rates of dynamic or continuous coating processes, that is, processes wherein the substrate moves continuously through a deposition device. Deposition rates for such deposition devices are commonly called « dynamic deposition rates » (DDR) and are used to express the deposition rate of the coating equipment itself, independently of the speed at which the substrate moves through the deposition equipment.

In an embodiment of the present invention the total flow rate of the boron-comprising precursors is comprised between 10 and 500 sccm (standard cubic centimeters per minute) per linear meter of plasma length, preferably between 50 and 500 sccm or between 50 and 400 sccm per linear meter of plasma length.

In an embodiment of the present invention the total flow rate of the silicon and boron-comprising precursors is between 10 and 750 sccm (standard cubic centimeters per minute) per linear meter of plasma length, preferably between 50 and 750 sccm or between 50 and 600 sccm per linear meter of plasma length.

As the case may be, stage c) may additionally comprise applying to the substrate an additional precursor, for example in order to include a specific additional oxide such as titanium oxide or zirconium oxide, to further improve mechanical and/or chemical durability and/or to increase the refractive index of the boron doped silicon oxide protective layer.

According to an embodiment of the present invention the boron doped silicon oxide protective layer comprises at least 80% by weight of silicon oxide SiO₂.

According to an embodiment of the present invention the boron doped silicon oxide protective layer comprises up to 15% by weight of titanium oxide, zirconium oxide or a mixture thereof.

The present invention is defined in the appended independent claims. Preferred embodiments are defined in the dependent claims.

### Examples

Boron doped silicon oxide protective layers were deposited as topmost layer on various glass glass substrates so as to form a multilayer coated glass substrate.

Substrate A was a 4mm thick normal clear soda lime glass substrate, provided with the following sequence of layers (Table 1), numbered starting from the glass surface before adding a protective layer of boron doped silicon oxide. These layers were deposited using magnetron sputtering.

**Table 1 - substrate A layer sequence**

| Layer number | Layer material | Layer thickness range (nm) |
|---|---|---|
| 1 | Zn₂SnO₄ | 25 - 35 |
| 2 | ZnO:Al | 3 - 8 |
| 3 | Ag | 10 - 11 |
| 4 | ZnO:Al | 2 - 10 |
| 5 | Zn₂SnO₄ | 25 - 30 |
| 6 | Si₃N₄ | 25 - 40 |
| 7 | Zn₂SnO₄ | 8 - 15 |
| 8 | Ti_{X}Zr_{y}O_{Z} | 2 - 5 |
| 9 | ZnO:Al | 3 - 8 |
| 10 | Ag | 13 - 15 |
| 11 | ZnO:Al | 2 - 10 |
| 12 | Zn₂SnO₄ | 5 - 10 |
| 13 | Si₃N₄ | 20 - 23 |
| 14 | Ti_{X}Zr_{y}O_{Z} | 1 - 3 |

| | | |
|---|---|---|
| ZnO:Al is an aluminum doped zinc oxide layer, comprising 2 to 10% by weight of aluminum. TiₓZr_{y}O_{z} denotes a mixed oxide of titanium and zirconium which comprises 65% by weight of titanium oxide and 35% by weight of zirconium oxide. | | |

The precursors used for the deposition of the protective layer are given in Table 2 below. In a vacuum chamber, the glass substrate was transported at a continuous speed on a roller conveyor beneath the PECVD source in a direction transversal to the length of the source. The glass substrate may be passed more than once beneath the PECVD source so as to achieve an intended layer thickness (number of passes).

The PECVD source used is made of two pairs of electrodes each 40cm long, placed perpendicular to the moving direction of the substrate. This gives an overall length of plasma of 80cm. A power of 16kW is applied to this plasma source, the applied power is 16kW/0.8m = 20 kW per linear meter of plasma source length. O₂ reactive gas flow rates are adjusted so as to reduce any amount of carbon in the coating to a non-detectable level. Deposition parameters are given in Table 3 below.

**Table 2**

| precursor | | | |
|---|---|---|---|
| A | TMDSO | 1,1,3,3-Tetramethyldisiloxane | Si comprising precursor |
| B | TTMSB | Tris(trimethylsilyl) borate | Si and B comprising precursor |
| C | TEOS | Tetraethyl orthosilicate | Si comprising precursor |
| D | TEB | Triethylborate | B comprising precursor |
| E | SiH4 | Silane | Si comprising precursor |

Before the deposition of the protective layer, the substrates were treated with an oxygen plasma using the same PECVD source. The O₂ flow rate was 2000 sccm and the applied power was 12.5 kW/m. Example 0 is a comparative substrate A on which no protective layer is deposited. Examples 1, 2, 9 and 10 are comparative samples coated with a silicon oxide layer without boron doping. Examples 3 to 6 and 11 to show the deposition possibilities using a precursor mixture. Examples 7 and 8 were performed using a single precursor.

**Table 3**

| example | Precursor(s) | precursor gas flow rate [sccm] | Power [kW/m] | Reactant gas, O2 flow rate [sccm] | speed [cm/min] | Passes |
|---|---|---|---|---|---|---|
| 0 | - | - | - | - | - | - |
| 1 | A | 68 | 20 | 1918 | 145 | 2 |
| 2 | A | 68 | 20 | 1918 | 80 | 2 |
| 3 | A B | 40 25 | 20 | 2400 | 222 | 2 |
| 4 | A | 40 | 20 | 2400 | 313 | 2 |
| | B | 35 | | | | |
| 5 | A | 40 | 20 | 2400 | 172 | 2 |
| | B | 35 | | | | |
| 6 | A | 20 | 20 | 2400 | 157 | 2 |
| | B | 25 | | | | |
| 7 | B | 24 | 20 | 2400 | 109 | 2 |
| 8 | B | 30 | 20 | 2400 | 121 | 2 |
| 9 | C | 70 | 20 | 2000 | 128 | 2 |
| 10 | C | 70 | 20 | 2000 | 138 | 2 |
| 11 | C | 50 | 20 | 2000 | 108 | 2 |
| | D | 20 | | | | |
| 12 | C | 20 | 20 | 2000 | 84 | 2 |
| | D | 20 | | | | |
| 13 | C | 10 | 20 | 2000 2000 | 51 | 2 |
| | D | 20 | | | | |
| 14 | C | 10 | 20 | | 55 | 2 |
| | D | 20 | | | | |
| 15 | C | 10 | 20 | 2000 | 68 | 2 |
| | D | 40 | | | | |

Table 4 shows the dynamic deposition rates (DDR) obtained for the different examples, refractive index boron content and thickness. Such deposition rates are significantly higher than what is obtainable by magnetron sputtering.

**Table 4**

| example | DDR [nm.m/min] | Refractive index at wavelength of 633nm | B content [at%] | Thickness [nm] |
|---|---|---|---|---|
| 1 | 119 | 1.46 | 0% | 165 |
| 2 | 119 | 1.46 | 0% | 300 |
| 3 | 183 | 1.46 | 4.6% | 165 |
| 4 | 258 | 1.46 | 7.5% | 165 |
| 5 | 258 | 1.46 | 7.5% | 300 |
| 6 | 129 | 1.46 | 9% | 165 |
| 7 | 90 | 1.46 | 12% | 165 |
| 8 | 100 | 1.46 | 12% | 170 |
| 9 | 109 | 1.46 | 0% | 170 |
| 10 | 117 | 1.46 | 0% | 170 |
| 11 | 92 | 1.46 | <2% | 170 |
| 12 | 72 | 1.46 | <2% | 170 |
| 13 | 44 | 1.46 | <2% | 170 |
| 14 | 46 | 1.46 | <2% | 170 |
| 15 | 58 | 1.46 | <2% | 170 |

X-ray fluorescence spectroscopy analysis was used to determine the B atomic percentage in the boron doped silicon oxide layers. For determining the carbon content the same coatings were deposited on silicon substrates and FTIR (Fourier transform Infrared Spectroscopy) spectra measured. No carbon bonds were detected.

Neutral salt spray test (NSST) - This test consists in subjecting the sample to the action, in a chamber maintained at 35°C, of a salt fog formed by spraying an aqueous solution containing 50 g/l sodium chloride (full details of this test are set out in International Standard ISO 9227-1990), for an exposure time of at least 5 days, alternatively at least 10 days, alternatively at least 21 days.

Cleveland test (Clev)- The test is run according to standard ISO 6270-1:1998, for at least 2.0 days, alternatively 5 days, alternatively 10 days, alternatively 15 days.

Climatic chamber test (CC) - The test consists in placing the samples in a chamber filled with an atmosphere of H₂O and subjected to temperature cycles each of 2 hours, during which the temperature varies from 45°C to 55°C returning to 45°C, for at least 2.0 days, alternatively 5 days, alternatively 10 days, alternatively 21 days. CC BB is the test carried out before heat treatment of the pane (before bake), while CC AB is the test carried out after heat treatment of the pane (after bake)
The results for each test described above are obtained by visually assessing samples in comparison with a defined scale of reference samples. Scales for the Cleveland, climatic chamber and salt fog tests are based on an internal scale from 0 to 5, with 0 corresponding to a standard sample having critical deterioration (such as pixels, deep dots, stretch marks and so on). The value of 5 corresponds to a perfect or substantially perfect surface, free of any deterioration sign. The intermediate values (down to the 0.25 unit), correspond to samples of the internal scale having different levels of deterioration, ranked in order of level of deteriorations. Acceptable values are from 3 to 5.

Table 5 below shows results for the different tests. Some samples are tested before heat treatment and after heat treatment. The heat treatment consist in placing the sample inside a convection furnace at a temperature of 670°C during 4 to 5 minutes.

**Table 5**

| Example | CC | CC | Clev | Clev |
|---|---|---|---|---|
| | Before heat treatment | After heat treatment | Before heat treatment | After heat treatment |
| | 3 days | 3 days | 3 days | 3 days |
| 0 | 3 | 3 | 3.5 | 3.5 |
| 1 | 5 | 2 | 4 | 5 |
| 2 | 5 | Haze > 5% | 5 | Haze > 5% |
| 3 | 4 | 5 | 5 | 5 |
| 4 | 5 | 5 | 5 | 5 |
| 5 | 5 | 2 | 5 | 1 |
| 6 | 5 | 5 | 5 | 5 |
| 7 | 5 | 5 | 5 | 5 |

While for examples 1 and 2, comprising silicon oxide without boron doping, some improvement before heat treatment is observed, a clearly lower performance is observed than for examples with a boron doped silicon oxide coating 3 to 7.

Substrate B was a 4mm thick normal clear soda lime glass substrate provided, by magnetron sputtering, with the following sequence of layers (table 5), numbered starting from the glass surface. Different protective layers of boron doped silicon oxide were then added by PECVD according to conditions of table 6. Then, a zirconium doped silicon oxide layer of 20nm thickness was added by magnetron sputtering. These layers were deposited using magnetron sputtering. The resulting multilayer coating is an antireflective coating. Examples 16 and 17 are comparative examples without boron doping.

**Table 5 - substrate B layer sequence**

| Layer number | Layer material | Layer thickness range (nm) |
|---|---|---|
| 1 | TiₓZr_{y}O_{z} | 12 |
| 2 | SiO₂:Al | 34 |
| 3 | TiₓZr_{y}O_{z} | 126 |

**Table 6**

| example | Precursor (s) | precursor gas flow rate [sccm] | Power [kW/m] | Reactant gas, O₂ flow rate [sccm] | speed [cm/min] | Passes |
|---|---|---|---|---|---|---|
| 16 | A | 64.3 | 20 | 1918 | 112 | 2 |
| 17 | E | 111 | 6.3 | 332 | 112.5 | 2 |
| 18 | B | 60 | 20 | 2400 | - | - |
| 19 | B | 30 | 20 | 2400 | 145 | 2 |

**Table 7**

| example | DDR [nm.m/min] | Refractive index at wavelength of 633nm | B content [at%] | Thickness [nm] |
|---|---|---|---|---|
| 16 | 120 | 1.46 | 0 | 70 |
| 17 | 120 | 1.46 | 0 | 70 |
| 18 | 200 | 1.46 | 12% | 70 |
| 19 | 120 | 1.46 | 12% | 70 |

**Table 8**

| example | Heat treatment 670°C, 5.5min | Aqueous solution at pH 13 for 48h |
|---|---|---|
| 16 | cracks | No defects |
| 17 | No defects | delamination |
| 18 | No defects | No defects |
| 19 | No defects | No defects |

Examples 16 to 19 all have nearly identical optical properties. Examples 16 and 17, comprising no boron doped silicon oxide protective layer, show little resistance to heat treatment or alkaline solutions respectively, whereas Examples 18 and 19, comprising a boron doped silicon oxide protective layer, show good resistance to both heat treatment and alkaline solutions.

## Claims

1. A glass substrate bearing a multilayer coating comprising a protective layer of boron doped silicon oxide, wherein the boron doped silicon oxide comprises
a. Si, O, B, wherein the boron content is comprised between 4 at 12 atomic % and
b. OH groups.

2. A glass substrate according to claim 1 wherein the protective layer is free of carbon.

3. A glass substrate according to any one preceding claim wherein the protective layer has a an FTIR absorbance peak area ratio A_{OH}/A_{SiOSi} of the -OH stretching vibrations absorption peak area to the Si-O-Si stretching vibration absorption peak area comprised between 0.25 and 0.5.

4. A glass substrate according to any one preceding claim wherein the protective layer has a thickness of at least 50nm and of at most 400nm.

5. A glass substrate according to any one preceding claim wherein the refractive index of the protective layer at a wavelength of 633nm is comprised between 1.4 and 1.5.

6. A glass substrate according to any one preceding claim wherein the protective layer comprises at least 80% by weight of SiO₂.

7. A glass substrate according to any one preceding claim wherein the protective layer comprises up to 15% by weight of titanium oxide, zirconium oxide or a mixture of titanium oxide and zirconium oxide.

8. A glass substrate according to any one of claims 1 to 6 wherein the protective layer essentially consists of Si, B, O and H.

9. A glass substrate according to any one preceding claim wherein the multilayer coating is selected from an antireflective coating, a UV reflective coating, an insulating low emissivity coating and a solar control coating.

10. A process for the deposition on a glass substrate of a protective boron doped silicon oxide layer comprising Si, O, and OH groups and wherein the boron content is comprised between 4 at 12 atomic %, comprising:
a. providing a glass substrate,
b. providing a plasma source, of linear hollow-cathode type, which source has a length, comprising at least one pair of hollow-cathode plasma generating electrodes, and comprises at least one electrode pair connected to an AC, DC or pulsed DC generator power source, for the deposition of said protective layer on the substrate,
c. injecting a plasma generating reactive gas comprising oxygen in the plasma source's electrodes at a flow rate of between 125 and 750 sccm per linear meter of plasma source length;
d. applying an electrical power to the plasma source of between 10 and 50 kW per linear meter of plasma source length, and,
e. injecting a precursor gas at a flow rate of between 500 and 2500 sccm per linear meter of plasma source length, the precursor gas being injected into the plasma in at least between the electrodes of each electrode pair of the plasma source, depositing the protective layer on the glass substrate by exposing the substrate to the plasma of the plasma source.

11. A process according to claim 10 wherein the precursor gas comprises at least one precursor comprising Si, at least one precursor comprising B and/or at least one precursor comprising Si and B.

12. A process according to claims 10 or 11 wherein the reactive gas is O₂ or a O₂-Ar mixture.

13. A process according to any one of claims 10 to 12 wherein the reactive gas flow rate is comprised between 2000 and 5000 sccm per linear meter of plasma source length.

14. A process according to any one of claims 10 to 13 wherein the precursor gas comprises at least one precursor selected from a silicon comprising precursor, a boron-comprising precursor and/or a silicon- and boron-comprising precursor and wherein the total flow rate of each precursor is comprised between 10 and 500 sccm

## Patentansprüche

1. Glassubstrat, das eine mehrschichtige Beschichtung trägt, die eine Schutzschicht aus bordotiertem Siliciumoxid umfasst, wobei das bordotierte Siliciumoxid umfasst
a. Si, O, B, wobei der Borgehalt in dem Bereich zwischen 4 und 12 Atom-% und liegt, und
b. OH-Gruppen.

2. Glassubstrat nach Anspruch 1, wobei die Schutzschicht frei von Kohlenstoff ist.

3. Glassubstrat nach einem der vorstehenden Ansprüche, wobei die Schutzschicht ein FTIR-Absorbanzpeak-Flächenverhältnis A_{OH}/A_{SiOSi} der -OH-Streckschwingungs-Absorptionspeakfläche zu der Si-O-Si-Streckschwingungs-Absorptionspeakfläche in dem Bereich zwischen 0,25 und 0,5 aufweist.

4. Glassubstrat nach einem der vorstehenden Ansprüche, wobei die Schutzschicht eine Dicke von wenigstens 50 nm und von höchstens 400 nm aufweist.

5. Glassubstrat nach einem der vorstehenden Ansprüche, wobei der Brechungsindex der Schutzschicht bei einer Wellenlänge von 633 nm in dem Bereich zwischen 1,4 und 1,5 liegt.

6. Glassubstrat nach einem der vorstehenden Ansprüche, wobei die Schutzschicht wenigstens 80 Gew.-% SiO₂ umfasst.

7. Glassubstrat nach einem der vorstehenden Ansprüche, wobei die Schutzschicht bis zu 15 Gew.-% Titanoxid, Zirkoniumoxid oder ein Gemisch aus Titanoxid und Zirkoniumoxid umfasst.

8. Glassubstrat nach einem der Ansprüche 1 bis 6, wobei die Schutzschicht im Wesentlichen aus Si, B, O und H besteht.

9. Glassubstrat nach einem der vorstehenden Ansprüche, wobei die mehrschichtige Beschichtung ausgewählt ist aus einer Antireflexbeschichtung, einer UV-reflektierenden Beschichtung, einer isolierenden Beschichtung mit niedrigem Emissionsvermögen und einer Sonnenschutzbeschichtung.

10. Verfahren zur Abscheidung einer bordotierten Siliciumoxid-Schutzschicht, die Si-, O- und OH-Gruppen umfasst, auf einem Glassubstrat, wobei der Borgehalt in dem Bereich zwischen 4 und 12 Atom-% liegt, umfassend:
a. Bereitstellen eines Glassubstrats,
b. Bereitstellen einer Plasmaquelle von dem linearen Hohlkathodentyp, wobei die Quelle eine Länge aufweist, die wenigstens ein Paar von Hohlkathoden-Plasmaerzeugungselektroden umfasst und wenigstens ein Elektrodenpaar umfasst, das mit einer AC-, DC- oder gepulsten DC-Generator-Stromquelle verbunden ist, für die Abscheidung der Schutzschicht auf das Substrat,
c. Injizieren eines plasmaerzeugenden reaktiven Gases, das Sauerstoff umfasst, in die Elektroden der Plasmaquelle mit einer Durchflussrate zvon wischen 125 und 750 sccm pro linearem Meter der Länge der Plasmaquelle;
d. Anlegen einer elektrischen Leistung an die Plasmaquelle von zwischen 10 und 50 kW pro linearem Meter der Länge der Plasmaquelle, und
e. Injizieren eines Vorläufergases mit einer Durchflussrate zwischen 500 und 2500 seem pro linearem Meter Länge der Plasmaquelle, wobei das Vorläufergas in das Plasma wenigstens zwischen den Elektroden jedes Elektrodenpaares der Plasmaquelle injiziert wird, Abscheiden der Schutzschicht auf das Glassubstrat durch Exponieren des Substrats gegenüber dem Plasma der Plasmaquelle.

11. Verfahren nach Anspruch 10, wobei das Vorläufergas wenigstens einen Vorläufer, der Si umfasst, wenigstens einen Vorläufer, der B umfasst, und/oder wenigstens einen Vorläufer, der Si und B umfasst, umfasst.

12. Verfahren nach Anspruch 10 oder 11, wobei das reaktive Gas O₂ oder ein O₂-Ar-Gemisch ist.

13. Verfahren nach einem der Ansprüche 10 bis 12, wobei die Strömungsrate des reaktiven Gases in dem Bereich zwischen 2000 und 5000 sccm pro linearem Meter der Länge der Plasmaquelle liegt.

14. Verfahren nach einem der Ansprüche 10 bis 13, wobei das Vorläufergas wenigstens einen Vorläufer ausgewählt aus einem siliciumhaltigen Vorläufer, einem borhaltigen Vorläufer und/oder einem silicium- und borhaltigen Vorläufer umfasst und wobei die Gesamtströmungsrate jedes Vorläufers in dem Bereich zwischen 10 und 500 sccm liegt.

## Revendications

1. Substrat de verre portant un revêtement multicouche comprenant une couche protectrice d'oxyde de silicium dopé au bore, dans lequel l'oxyde de silicium dopé au bore comprend
a. Si, O, B, la teneur en bore étant comprise entre 4 et 12 % atomique et
b. des groupes OH.

2. Substrat de verre selon la revendication 1, dans lequel la couche protectrice est exempte de carbone.

3. Substrat de verre selon l'une quelconque des revendications précédentes, dans lequel la couche protectrice a un rapport de surface de pic d'absorbance FTIR A_{OH}/A_{SiOSi} de la surface de pic d'absorbance des vibrations d'étirement -OH sur la surface de pic d'absorbance des vibrations d'étirement Si-O-Si compris entre 0,25 et 0,5.

4. Substrat de verre selon l'une quelconque des revendications précédentes, dans lequel la couche protectrice a une épaisseur d'au moins 50 nm et d'au plus 400 nm.

5. Substrat de verre selon l'une quelconque des revendications précédentes, dans lequel l'indice de réfraction de la couche protectrice à une longueur d'onde de 633 nm est compris entre 1,4 et 1,5.

6. Substrat de verre selon l'une quelconque des revendications précédentes, dans lequel la couche protectrice comprend au moins 80 % en poids de SiO₂.

7. Substrat de verre selon l'une quelconque des revendications précédentes, dans lequel la couche protectrice comprend jusqu'à 15 % en poids d'oxyde de titane, d'oxyde de zirconium ou d'un mélange d'oxyde de titane et d'oxyde de zirconium.

8. Substrat de verre selon l'une quelconque des revendications 1 à 6, dans lequel la couche protectrice est essentiellement constituée de Si, B, O et H.

9. Substrat de verre selon l'une quelconque des revendications précédentes, dans lequel le revêtement multicouche est choisi parmi un revêtement antireflet, un revêtement réfléchissant les UV, un revêtement isolant à faible émissivité et un revêtement de contrôle solaire.

10. Procédé pour le dépôt sur un substrat de verre d'une couche de protection d'oxyde de silicium dopé au bore comprenant des groupes Si, O, et OH et dans lequel la teneur en bore est comprise entre 4 et 12 % atomique, comprenant :
a. la fourniture d'un substrat de verre,
b. la fourniture d'une source de plasma de type à cathode creuse linéaire, présentant une longueur, comprenant au moins une paire d'électrodes génératrices de plasma à cathode creuse, et comprend au moins une paire d'électrodes reliées à une source de puissance du générateur de courant continu alternatif, continu ou continu pulsé, pour le dépôt de ladite couche de protection sur le substrat,
c. l'injection d'un plasma générant un gaz réactif comprenant de l'oxygène dans les électrodes de la source de plasma à un débit compris entre 125 et 750 sccm par mètre linéaire de longueur de la source de plasma ;
d. l'application d'une puissance électrique à la source de plasma comprise entre 10 et 50 kW par mètre linéaire de longueur de source de plasma, et,
e. l'injection d'un gaz précurseur à un débit compris entre 500 et 2 500 sccm par mètre linéaire de longueur de source de plasma, le gaz précurseur étant injecté dans le plasma dans au moins entre les électrodes de chaque paire d'électrodes de la source de plasma, déposant la couche de protection sur le substrat de verre en exposant le substrat au plasma de la source de plasma.

11. Procédé selon la revendication 10, dans lequel le gaz précurseur comprend au moins un précurseur comprenant Si, au moins un précurseur comprenant B et/ou au moins un précurseur comprenant Si et B.

12. Procédé selon la revendication 10 ou 11, dans lequel le gaz réactif est O₂ ou un mélange O₂-Ar.

13. Procédé selon l'une quelconque des revendications 10 à 12, dans lequel le débit de gaz réactif est compris entre 2 000 et 5 000 sccm par mètre linéaire de longueur de source de plasma.

14. Procédé selon l'une quelconque des revendications 10 à 13, dans lequel le gaz précurseur comprend au moins un précurseur choisi parmi un précurseur comprenant du silicium, un précurseur comprenant du bore et/ou un précurseur comprenant du silicium et du bore et, dans lequel le débit total de chaque précurseur est compris entre 10 et 500 sccm.
